(19) Europäisches Patentamt
European Patent Office
Office européen des brevets

(11) EP 1 359 790 B1

(12) **EUROPEAN PATENT SPECIFICATION**

(45) Date of publication and mention of the grant of the patent:
**29.10.2008 Bulletin 2008/44**

(51) Int Cl.:
***H05B 33/20*** *(2006.01)* ***H05B 33/14*** *(2006.01)*
***C09K 11/06*** *(2006.01)* ***H01L 51/50*** *(2006.01)*

(21) Application number: **03076082.1**

(22) Date of filing: **14.04.2003**

(54) **Organic light-emitting diode devices with improved operational stability**

Organische lichtemittierende Dioden mit verbesserter Betriebsstabilität

Diodes électroluminescentes organiques à stabilité de fonctionnement améliorée

(84) Designated Contracting States:
**DE FR GB**

(30) Priority: **24.04.2002 US 131801**

(43) Date of publication of application:
**05.11.2003 Bulletin 2003/45**

(73) Proprietor: **Eastman Kodak Company**
**Rochester NY 14650-2201 (US)**

(72) Inventor: **Jarikov, Viktor V.,**
**c/o Eastman Kodak Company**
**Rochester,**
**New York 14650-2201 (US)**

(74) Representative: **Weber, Etienne Nicolas et al**
**Kodak Industrie**
**Département Brevets - CRT**
**Zone Industrielle**
**71102 Chalon sur Saône Cedex (FR)**

(56) References cited:
**EP-A- 1 162 674**
**EP-A- 1 221 473**
**WO-A-99/53724**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 359 790 B1

## Description

The present invention relates to organic light emitting diode devices and more particularly to the design of the composition of the organic layers for improvements in operational stability.

Organic light emitting diodes (OLED), also known as organic electroluminescent (EL) devices, are a class of electronic devices that emit light in response to an electrical current applied to the device. The structure of an OLED device generally includes an anode, an organic EL medium, and a cathode. The term, organic EL medium, herein refers to organic materials or layers of organic materials disposed between the anode and the cathode in the OLED device. The organic EL medium may include low molecular weight compounds, high molecular weight polymers, oligimers of low molecular weight compounds, or biomaterials, in the form of a thin film or a bulk solid. The medium can be amorphous or crystalline. Organic electroluminescent media of various structures have been described in the prior art. Dresner, in RCA Review, 30, 322 (1969), described a medium comprising a single layer of anthracene film. Tang and others in Applied Physics Letters, 51, 913 (1987), Journal of Applied Physics, 65, 3610 (1989), and commonly-assigned US-A-4,769,292, reported an EL medium with a multi-layer structure of organic thin films, and demonstrated highly efficient OLED devices using such a medium. In some OLED device structures the multi-layer EL medium includes a hole-transport layer adjacent to the anode, an electron-transport layer adjacent to the cathode, and disposed in between these two layers, a luminescent layer. Furthermore, in some preferred device structures, the luminescent layer is constructed of a doped organic film comprising an organic material as the host and a small concentration of a fluorescent compound as the dopant. Improvements in EL efficiency, chromaticity, and stability have been obtained in these doped OLED devices by selecting an appropriate dopant-host composition. The dopant, being the dominant emissive center, is selected to produce the desirable EL colors. Examples of the doped luminescent layer reported by Tang and others,. in commonly-assigned US-A-4,769,292 and by Chen and others in commonly-assigned US-A-5,908,581 are: tris(8-quinolinol)aluminum (AIQ) host doped with coumarin dyes for green emitting OLEDs; and A1Q doped with 4-dicyanomethylene-4H-pyrans (DCMs) for orange-red emitting OLEDs. Shi and others., in commonly assigned US-A-5,593,788, disclosed that a long operational life was obtained in an OLED device by using a quinacridone compound as the dopant in an A1Q host. Bryan and others., in commonly assigned US-A-5,141,671, disclosed a luminescent layer containing perylene or a perylene derivative as a dopant in a blue emitting host. They showed that a blue emitting OLED device with an improved operational stability was obtained. In both disclosures, the incorporation of selected fluorescent dopants in the luminescent layer is found to improve substantially the overall OLED device performance parameters. Co-doping of luminescent layer with anthracene derivatives results in devices with better stability as shown in JP 99273861 and JP 284050. Doping the hole-transport layer with materials that impede hole-transport and co-doping hole-transport material into electron-transporting A1Q leads to the improved device lifetimes, Popovic and others. Thin Solid Films 2000, 363, 6; SPIE 1998, 3476, 68.

The most common formulation of the doped luminescent layer includes only a single dopant in a host matrix. However, in a few instances, incorporation of more than one dopant in the luminescent layer was found to be beneficial in improving stability. Using a luminescent layer containing rubrene, a yellow emitting dopant, and DCJ 4-(dicyanomethylene)-2-methyl-6-[2-(4-julolidyl)ethenyl]-4H-pyran, a red emitting dopant, in an A1Q host it is possible to produce a red emitting OLED device with improved operational stability, Hamada and others in Applied Phys. Lett. 75, 1682 (1999); EP1162674. Here rubrene functions as a co-dopant in mediating energy transfer from the A1Q host to the DCJ emitter. Generally, in dual dopant systems, it has been noted that the operational stability tends to increase compared to that of the single dopant systems.

Although EL efficiency, color, and stability have been improved significantly using doped luminescent layers of various compositions, the problem of low operational stability persists. Insufficient stability presents the greatest obstacle for many desirable practical applications.

It is an object of the present invention to provide OLED devices with improved operational stability.

It is another object of the present invention to provide OLED devices with improved luminance efficiency.

It is another object of the present invention to provide a color OLED device with improved color chromaticity.

It is a further object of the present invention to provide specifically OLED devices with improved operational stability, luminance efficiency, and chromaticity.

These objects are achieved in an organic light emitting device comprising a substrate, an anode and a cathode disposed over the substrate, and a luminescent layer disposed between the anode and the cathode wherein the luminescent layer includes a host and at least one dopant, the host of the luminescent layer is selected to include a solid organic material comprising a mixture of at least two components, one of which is capable of forming both monomer state and an aggregate state.

These objects are further achieved in an organic light emitting device, comprising:

(a) a substrate;
(b) an anode and a cathode disposed over the substrate;

(c) a luminescent layer disposed between the anode and the cathode wherein the luminescent layer includes a host and at least one dopant;

(d) the host of the luminescent layer being selected to include a solid organic material comprising a mixture of at least two components wherein:

(i) the first component of the mixture is an organic compound that is capable of transporting either electrons or holes or both and is capable of forming both monomer state and an aggregate state and further is capable of forming the aggregate state either in the ground electronic state or in the excited electronic state that results in a different absorption or emission spectrum or both relative to the absorption or emission spectrum or both of the monomer state, respectively; and

(ii) the second component of the mixture is an organic compound that is capable of forming a continuous and substantially pin-hole-free layer; and

(e) the dopant of the luminescent layer being selected to produce light from the light-emitting device.

An advantage of the present invention is that, with an appropriate selection of the first and second host components and the dopants in the luminescent layer, OLED devices with extraordinarily long lifetimes are produced.

Another advantage of the present invention is that it provides OLED devices with high operational stability, lower drive voltage, excellent luminance efficiency and color chromaticity, and with luminance efficiency and color chromaticity essentially independent of the current density.

Another advantage of the present invention is that it provides OLED devices that are suitable for high-brightness lighting and display applications.

The drawings are necessarily of a schematic nature, since the individual layers are too thin and the thickness differences of the various elements too great to permit depiction to scale or to permit convenient proportionate scaling.

FIG. 1 is schematic structure of an OLED with an organic EL medium;

FIG. 2 and FIG. 3 are two schematic OLED structures showing two different configurations of the organic EL medium;

FIG. 4 shows photoluminescence spectra of an OLED device where the light-emitting layer is composed of naphtho [2,3-*a*]pyrene and AlQ; excitation wavelength is 430 nm;

FIG. 5 shows photoluminescence spectra of the same OLED device where the light-emitting layer is composed of naphtho[2,3-*a*]pyrene and AlQ; excitation wavelength is 470 nm;

FIG. 6 shows electroluminescence spectra of the same OLED device where the light-emitting layer is composed of naphtho[2,3-*a*]pyrene and AlQ; current density is 20 $mA/cm^2$; and

FIG. 7 shows electroluminescence spectra of an OLED device where the light-emitting layer is composed of naphtho [2,3-*a*]pyrene and TBADN; current density is 20 $mA/cm^2$.

FIG. 1 illustrates the structure of an OLED device of the simplest construction practiced in the present invention. In this structure, OLED device 100 includes an anode 120, an EL medium 130, and a cathode 140, disposed upon a substrate 110. In operation, an electrical current is passed through the OLED by connecting an external current or voltage source with electrical conductors 10 to the anode and the cathode, causing light to be emitted from the EL medium. The light may exit through either the anode or the cathode or both as desired and depending on their optical transparencies. The EL medium includes a single layer or a multi-layer of organic materials.

FIG. 2 illustrates the structure of another OLED device of the present invention. In this structure, OLED device 200 includes a substrate 210 and an EL medium 230, disposed between anode 220 and cathode 240. EL medium 230 includes a hole-transport layer 231 adjacent to the anode, an electron-transport layer 233 adjacent to the cathode, and a luminescent layer 232 disposed between the hole-transport layer and the electron-transport layer. In operation, an electrical current is passed through the OLED device by connecting an external current or voltage source with electrical conductors 10 to the anode and the cathode. This electrical current, passing through the EL medium, causes light to be emitted primarily from the luminescent layer 232. Hole-transport layer 231 carries the holes, that is, positive electronic charge carriers, from the anode to the luminescent layer. Electron-transport layer 233 carries the electrons, that is, negative electronic charge carriers, from the cathode to the luminescent layer 232. The recombination of holes and electrons produces light emission, that is, electroluminescence, from the luminescent layer 232.

FIG. 3 illustrates yet another structure of an OLED device of the present invention. In this structure, OLED device 300 includes a substrate 310 and an EL medium 330 disposed between anode 320 and cathode 340. EL medium 330 includes a hole-injection layer 331, a hole-transport layer 332, a luminescent layer 333, an electron-transport layer 334, and an electron-injection layer 335. Similarly to OLED device 200 of FIG. 2, the recombination of electrons and holes produces emission from the luminescent layer 333. The provision of the hole-injection layer 331 and the electron-injection layer 335 serves to reduce the barriers for carrier injection from the respective electrodes. Consequently, the

drive voltage required for the OLED device can be reduced.

FIG. 4 shows representative absolute photoluminescence (PL) spectra of an OLED device where the light-emitting layer is composed of naphtho[2,3-*a*]pyrene and A1Q. It can be seen that the higher the volume % of naphtho [2,3-a]pyrene in the layer the more emission spectrum is shifted to the red. This signals formation of the aggregate state the concentration of which and the average size of which increases with increasing volume % of naphtho[2,3-a]pyrene. The excitation wavelength is 430 nm and thus both A1Q and naphtho[2,3-a]pyrene are excited resulting in an emission spectrum composed of the photoluminescence of both A1Q and naphtho[2,3-a]pyrene, the latter being in the monomer state or the aggregate state or both.

FIG. 5 shows representative absolute photoluminescence (PL) spectra of the OLED device of FIG. 4 obtained with the excitation wavelength of 470 nm. Here primarily naphtho[2,3-a]pyrene is excited resulting in an emission spectrum composed almost exclusively of the photoluminescence of naphtho[2,3-a]pyrene in its monomer state or aggregate state or both.

FIG. 6 shows the corresponding absolute electroluminescence (EL) spectra of the OLED device of FIG. 4 and FIG. 5. It can be seen that the EL spectra resemble the PL spectra of FIG. 4 closely. This signals that the singlet excites states of both A1Q and naphtho[2,3-a]pyrene are produced in an operating device. Thus, the EL spectrum is composed of the photoluminescence of both A1Q and naphtho[2,3-a]pyrene, the latter being in its monomer state or aggregate state or both depending on the volume % of naphtho[2,3-a]pyrene in the luminescent layer.

FIG. 7 shows the absolute EL spectra of an OLED device where the light-emitting layer is composed of naphtho [2,3-*a*]pyrene and TBADN. It can be seen that the EL spectra behave similarly to those of FIG. 6. This signals that formation of an aggregate state of naphtho[2,3-a]pyrene occurs in a nonpolar TBADN environment as well as in polar A1Q environment. Thus, the EL spectrum is composed primarily of the emission spectrum of naphtho[2,3-a]pyrene in its monomer state in the 2% case, while in the 20% case the emission is almost solely that of naphtho[2,3-a]pyrene in its aggregate state.

According to the present invention, the luminescent layer (either layer 232 of FIG. 2 or layer 333 of FIG. 3) is primarily responsible for the electroluminescence emitted from the OLED device. One of the most commonly used formulations for this luminescent layer is an organic thin film including a host and one or more dopants. The host serves as the solid medium or matrix for the transport and recombination of charge carriers injected from the anode and the cathode. The dopant, usually homogeneously distributed in the host in small quantity, provides the emission centers where light is generated. Following the teaching of the prior art, the present invention uses a luminescent layer including a host and a dopant, but it distinguishes over the prior art that the host of the present invention is a mixture having at least two components, each component having specific electronic properties. The selection of these host components and compatible dopant materials is in accordance with the following criteria:

1. The host is a solid organic thin film having at least two uniformly mixed host components;
2. The first component of the mixture is an organic compound that is capable of transporting either electrons or holes or both;
3. The first component of the mixture is capable of forming both monomer state and an aggregate state;
4. The first component of the mixture is capable of forming the aggregate state either in the ground electronic state or in the excited electronic state;
5. The first component of the mixture is capable of forming the aggregate state that results in a different absorption or emission spectrum or both relative to the absorption or emission spectrum or both of the monomer state, respectively (the aggregate state can emit or absorb or both to the red or to the blue of the emission or absorption spectrum or both of the monomer state, respectively);
6. The second component of the mixture is an organic compound that is capable of forming a continuous and substantially pin-hole-free layer;
7. The dopant is an organic luminescent compound capable of accepting the energy released from the recombination of electrons and holes in either the first or second host components, and emitting the energy as light.

Following the selection criteria of this invention, OLED devices have been constructed having excellent operational stability. Importantly, for red devices the luminance efficiency measured in candelas per ampere significantly increases compared to the system without the first component and remains constant over a large range of brightness or current densities. In addition, the color chromaticity is greatly improved and the drive voltage is reduced. This is a distinct advantage over the prior art, where such operational stability improvements over comparative examples combined with such long lifetimes have never been demonstrated, the luminance efficiency often decreases, or otherwise varies, with increasing brightness or current density, color chromaticity is often compromised, and drive voltage often increases. Another important advantage is that the chromaticity also remains essentially constant, independent of the brightness or current density. Thus, the problem of color shift with brightness in an OLED device is also eliminated.

Preferred materials for the first host component of the luminescent layer of this invention include a class of

compounds which, for the purpose of this invention, will be referred to as benzenoid compounds. The benzenoid compounds comprise polycyclic hydrocarbons (PAH) and combinations of two or more PAH. In benzenoid compounds formed by combination of two or more PAH, the PAH are connected together via a single chemical bond or linked via a saturated or unsaturated hydrocarbon group. The list of PAH useful as building blocks for benzenoid compounds or derivatives thereof includes:

1. Benzene
2. Naphthalene
3. Anthracene
4. Phenanthrene
5. Naphthacene
6. Pyrene
7. Pentacene
8. Perylene
9. Coronene
10. Chrysene

The list of preferred benzenoid compounds or derivatives thereof as materials for the first host component of the luminescent layer of this invention include:

1. Picene
2. Pericyclene
3. Benzo[ghi]perylene
4. Benzo[a]pyrene
5. Benzo[e]pyrene
6. Benzo[a]naphthacene
7. Naphtho[2,3-a]pyrene
8. Naphtho[2,3-e]pyrene
9. Rubicene
10. Anthanthrene
11. Fluoranthene
12. Benzo[*a*]coronene
13. Dibenzo[*b,def*]chrysene
14. Naphtho[2,3-*a*]coronene
15. Dibezo[cd,lm]perylene
16. Benzo[*ghi*]naphtho[*cde*}perylene
17. Benzo[b]perylene
18. Benzo[*a*]naphthacene
19. Benzo[a]perylene
20. Naphtho[8,1,2-bcd]perylene
21. Dibenzo[b,k]perylene
22. Dibenzo[b,n]perylene
23. Naphtho[1,2-a]pyrene
24. Naphtho[1,2-e]pyrene
25. Benzo[rst]pentaphene
26. Dibenzo[def,p]chrysene
27. Dibenzo[fg,op]naphthacene
28. Dibenzo[h,rst]pentaphene
29. Terrylene

Any of the above listed PAH, and any benzenoid compounds formed by the combination of one or more of the above listed PAH, are useful as the first host component, and, importantly, the compounds do not have to be film forming materials at room temperature. The second host component must be capable of forming continuous amorphous films.

Representative examples of useful benzenoid compounds in which the PAH are connected together via single chemical bonds include:

1) Pyrene-pyrene
2) Pyrene-benzene-pyrene

3) Perylene-perylene
4) Pyrene-perylene
5) Benzopyrene-benzopyrene
6) Coronene-perylene
7) Benzo[ghi]perylene-pyrene
8) Naphthopyrene-pyrene
9) Perylene-naphthacene
10) Naphthacene-pyrene
11) Naphthacene-perylene
12) Fluoranthene-benzopyrene

In the above examples, a hyphen represents a single chemical bond between PAH moieties. Useful benzenoid compounds include compounds such as PAH groups linked by one or more hydrocarbon groups. Any of the above listed benzenoid compounds substituted with one or more hydrocarbon groups are useful.

Particularly preferred materials for the first host component of the luminescent layer of this invention include benzenoid compounds of the following structures:

(a)

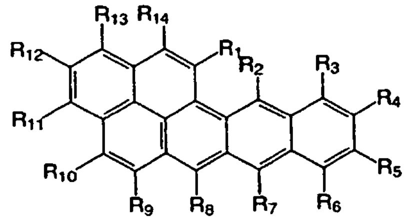

wherein:

substituents $R_1$ through $R_{14}$ are each individually hydrogen, alkyl of from 1 to 24 carbon atoms, aryl, or substituted aryl of from 5 to 30 carbon atoms; or any two adjacent $R_1$ through $R_{14}$ substituents form an annelated benzo or naphtho substituent or its alkyl or aryl substituted derivative; or any two $R_1$ through $R_{14}$ substituents form a 1,2-benzo, 1,2-naphtho, 2,3-naphtho, or 1,8-naphtho substituent or their alkyl or aryl substituted derivative; or

(b)

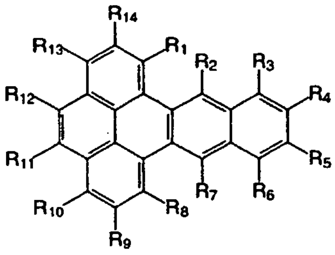

wherein:

substituents $R_1$ through $R_{14}$ are each individually hydrogen, alkyl of from 1 to 24 carbon atoms, aryl, or substituted aryl of from 5 to 30 carbon atoms; or any two adjacent $R_1$ through $R_{14}$ substituents form an annelated benzo or naphtho substituent or its alkyl or aryl substituted derivative; or any two $R_1$ through $R_{14}$ substituents form a 1,2-benzo, 1,2-naphtho, 2,3-naphtho, or 1,8-naphtho substituent or their alkyl or aryl substituted derivative; or

(c)

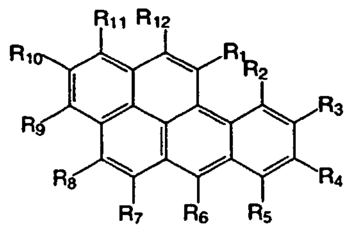

wherein:

substituents $R_1$ through $R_{12}$ are each individually hydrogen, alkyl of from 1 to 24 carbon atoms, aryl, or substituted aryl of from 5 to 30 carbon atoms; or any two adjacent $R_1$ through $R_{12}$ substituents form an annelated benzo or naphtho substituent or its alkyl or aryl substituted derivative; or any two $R_1$ through $R_{12}$ substituents form a 1,2-benzo, 1,2-naphtho, 2,3-naphtho, or 1,8-naphtho substituent or their alkyl or aryl substituted derivative; or

(d)

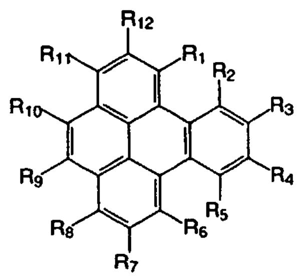

wherein:

substituents $R_1$ through $R_{12}$ are each individually hydrogen, alkyl of from 1 to 24 carbon atoms, aryl, or substituted aryl of from 5 to 30 carbon atoms; or any two adjacent $R_1$ through $R_{12}$ substituents form an annelated benzo or naphtho substituent or its alkyl or aryl substituted derivative; or any two $R_1$ through $R_{12}$ substituents form a 1,2-benzo, 1,2-naphtho, 2,3-naphtho, or 1,8-naphtho substituent or their alkyl or aryl substituted derivative; or

(e)

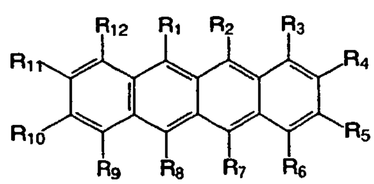

wherein:

substituents $R_1$ through $R_{12}$ are each individually hydrogen, alkyl of from 1 to 24 carbon atoms, aryl, or substituted aryl of from 5 to 30 carbon atoms; or any two adjacent $R_1$ through $R_{12}$ substituents form an annelated benzo or naphtho substituent or its alkyl or aryl substituted derivative; or any two $R_1$ through $R_{12}$ substituents form a 1,2-benzo, 1,2-naphtho, 2,3-naphtho, or 1,8-naphtho substituent or their alkyl or aryl substituted derivative; or

(f)

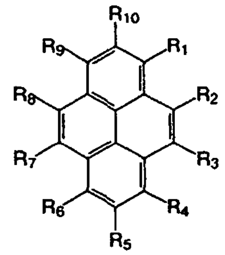

wherein:

substituents $R_1$ through $R_{10}$ are each individually hydrogen, alkyl of from 1 to 24 carbon atoms, aryl, or substituted aryl of from 5 to 30 carbon atoms; or any two adjacent $R_1$ through $R_{10}$ substituents form an annelated benzo or naphtho substituent or its alkyl or aryl substituted derivative; or any two $R_1$ through $R_{10}$ substituents form a 1,2-benzo, 1,2-naphtho, 2,3-naphtho, or 1,8-naphtho substituent or their alkyl or aryl substituted derivative;

(g)

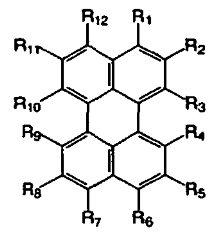

wherein:

substituents $R_1$ through $R_{12}$ are each individually hydrogen, alkyl of from 1 to 24 carbon atoms, aryl, or substituted aryl of from 5 to 30 carbon atoms; or any two adjacent $R_1$ through $R_{12}$ substituents form an annelated benzo or naphtho substituent or its alkyl or aryl substituted derivative; or any two $R_1$ through $R_{12}$ substituents form a 1,2-benzo, 1,2-naphtho, 2,3-naphtho, or 1,8-naphtho substituent or their alkyl or aryl substituted derivative;

(h)

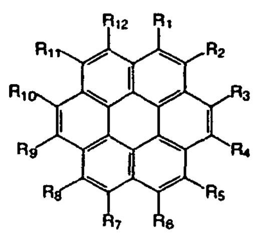

wherein:

substituents $R_1$ through $R_{12}$ are each individually hydrogen, alkyl of from 1 to 24 carbon atoms, aryl, or substituted aryl of from 5 to 30 carbon atoms; or any two adjacent $R_1$ through $R_{12}$ substituents form an annelated benzo or naphtho substituent or its alkyl or aryl substituted derivative; or any two $R_1$ through $R_{12}$ substituents form a 1,2-benzo, 1,2-naphtho, 2,3-naphtho, or 1,8-naphtho substituent or their alkyl or aryl substituted derivative;

(i)

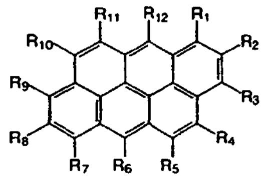

wherein:

substituents $R_1$ through $R_{12}$ are each individually hydrogen, alkyl of from 1 to 24 carbon atoms, aryl, or substituted aryl of from 5 to 30 carbon atoms; or any two adjacent $R_1$ through $R_{12}$ substituents form an annelated benzo or naphtho substituent or its alkyl or aryl substituted derivative; or any two $R_1$ through $R_{12}$ substituents form a 1,2-benzo, 1,2-naphtho, 2,3-naphtho, or 1,8-naphtho substituent or their alkyl or aryl substituted derivative;

(j)

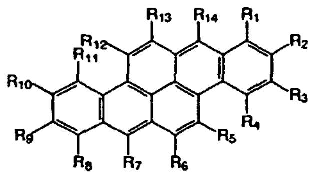

wherein:

substituents $R_1$ through $R_{14}$ are each individually hydrogen, alkyl of from 1 to 24 carbon atoms, aryl, or substituted aryl of from 5 to 30 carbon atoms; or any two adjacent $R_1$ through $R_{14}$ substituents form an annelated benzo or naphtho substituent or its alkyl or aryl substituted derivative; or any two $R_1$ through $R_{14}$ substituents form a 1,2-benzo, 1,2-naphtho, 2,3-naphtho, or 1,8-naphtho substituent or their alkyl or aryl substituted derivative;

(k)

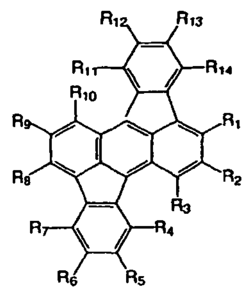

wherein:

substituents $R_1$ through $R_{14}$ are each individually hydrogen, alkyl of from 1 to 24 carbon atoms, aryl, or substituted aryl of from 5 to 30 carbon atoms; or any two adjacent $R_1$ through $R_{14}$ substituents form an annelated benzo or naphtho substituent or its alkyl or aryl substituted derivative; or any two $R_1$ through $R_{14}$ substituents form a 1,2-benzo, 1,2-naphtho, 2,3-naphtho, or 1,8-naphtho substituent or their alkyl or aryl substituted derivative;

(l)

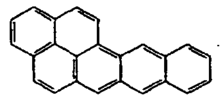
Naphtho[2,3-*a*]pyrene

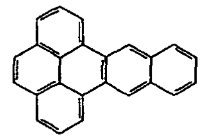
Naphtho[2,3-*e*]pyrene

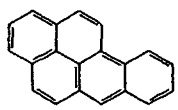
Benzo[*a*]pyrene

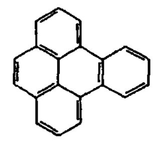
Benzo[*e*]pyrene

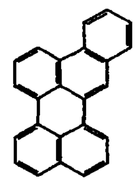
Benzo[b]perylene

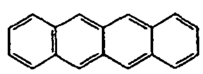
Naphthacene

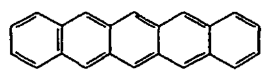
Pentacene

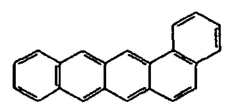
Benzo[*a*]naphthacene

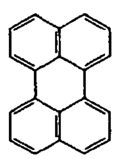
Perylene

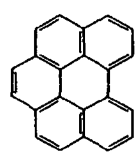
Benzo[*ghi*]perylene

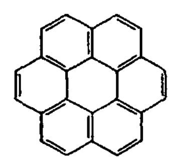
Coronene

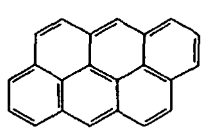
Anthanthrene

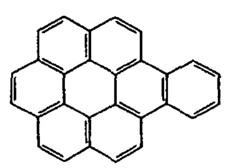
Benzo[*a*]coronene

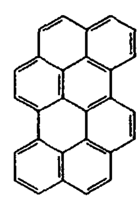
Benzo[*ghi*]naphtho[*cde*}perylene

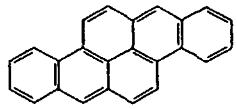
Dibenzo[*b,def*]chrysene

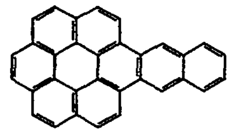
Naphtho[2,3-*a*]coronene

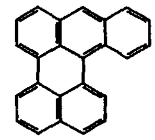
Benzo[a]perylene

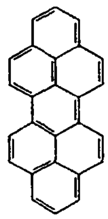
Dibezo[*cd,lm*]perylene

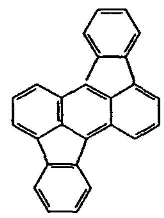
Rubicene

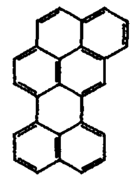
Naphtho[8,1,2-bcd]perylene

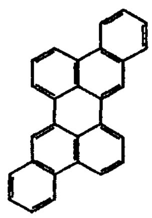
Dibenzo[b,k]perylene

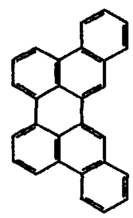
Dibenzo[b,n]perylene

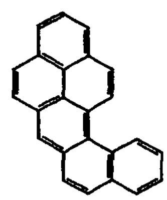
Naphtho[1,2-a]pyrene

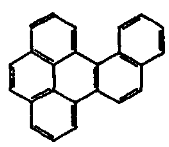
Naphtho[1,2-e]pyrene

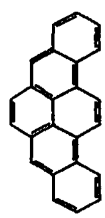
Benzo[rst]pentaphene

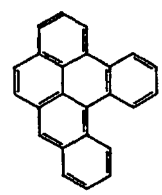
Dibenzo[def,p]chrysene

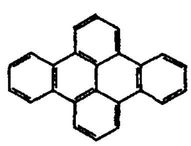
Dibenzo[fg,op]naphthacene

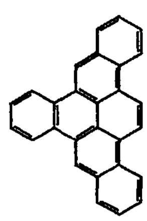
Dibenzo[h,rst]pentaphene

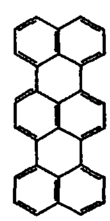
Terrylene

One particular selection criterion for the first host component is that the organic compound should have a molecular structure that enables it to form both monomer state and aggregate state. The aggregate state can be formed by at least two molecules of the same compound, such as the first host component, or by at least two molecules of two different compounds, such as the first and second host components. The following discussion will be focused on the first case. The monomer state is defined as a state where molecules of the first host component do not interact with each other and thus behave as single molecules in a solid solution of the second component. Thus, in particular their absorption and emission processes involve just one molecule. The absence of the interaction may evolve for example due to the intrinsic lack of forces that enable the interaction, distances between the molecules being too large, improper geometry, and other reasons. The aggregate state is defined as a state formed by an interaction, for example such as commonly known in the art van der Waals forces or by commonly known in the art charge-transfer interactions, of at least two molecules. It has physical and chemical properties different from those of the monomer state. In particular, two or more molecules may participate in cooperative absorption or emission or both, that is absorption or emission or both can only be understood as arising from molecular complexes or molecular aggregates. When two or more molecules act cooperatively to absorb a photon, it is said that the absorption aggregate exists in the ground electronic state. When two or more molecules act cooperatively to emit a photon, it is said that the exciplex, or a molecular complex or molecular aggregate, exists in the excited electronic state. The absorption aggregate need not form an exciplex upon excitation and the exciplex need not emit to produce a ground state aggregate. Thus, the aggregate state can exist in either ground electronic state or excited electronic state or both. An aggregate state may be only weakly associated in the ground electronic state (the energy of van der Waals interactions ~ 1-3 kcal/mol) but more strongly associated in its excited electronic state (the energy of van der Waals interaction ~ 3-10 kcal/mol). The simplest aggregate state in the ground electronic state is often called a dimer, that is an aggregate state formed by two molecules in their ground electronic states. The aggregate state in the excited electronic state is called an excimer and in the simplest case is formed by two molecules one of which prior to formation of the exciplex was in the ground electronic state and the other was in the excited electronic state. One of the most commonly observed features of aggregate states is that either their absorption spectrum or their emission spectrum or both are shifted compared to the absorption spectrum or emission spectrum or both, respectively, of the monomer state. The shift may occur to the red or to the blue. On the other hand, the absorption or emission spectra of both of aggregate states may contain new features such as peaks and shoulders positioned to either red or blue compared to the absorption or emission spectrum or both of the monomer state, respectively. Another most commonly observed characteristic of aggregate states is that the intensity and sometimes the position (wavelength) of the new or shifted absorption or emission or both depend on concentration of molecules that form the aggregate state. With increasing concentration, the intensity of shifted absorption or emission features or both may increase due to the increasing concentration of the aggregate states, while the position, or wavelength, may shift too due to the increase in the size (number of molecules involved in the formation) of the aggregate states. For reference, these definitions can be found in N.J. Turro, Modern Molecular Photochemistry, University Science Books, Sausalito, CA 1991.

For some organic compounds, their molecular structure is such that their aggregates in excited electronic states are emissive, and thus can be easily observed by measuring fluorescence emission spectra as a function of concentration, for example FIG. 4 and FIG. 5. Compounds that form emissive and highly emissive aggregate states are potentially the most useful as first host components. However, there are many organic compounds that form aggregate states which are not emissive or weakly emissive. This can lead to a decrease in the efficiency of electroluminescence and photoluminescence. Nevertheless, for some such compounds the lifetime of an aggregate state in the excited electronic state can be sufficiently long, while the rate of electronic excitation energy to the luminescent dopant is sufficiently high. Therefore, such compounds could also be useful as first host components that do not compromise the luminance efficiency.

Another important criteria for selection of compounds as fist host components is that the aggregate states of this compound should have such spectroscopic characteristics, namely absorption and emission spectra, lifetime, and oscillator strength, that efficient transfer of electronic excitation energy to the luminescent dopant of appropriate color is insured.

Many of the benzenoid compounds found useful as the first host component in the present invention have a flat rigid geometry, which encourages formation of aggregate states. Many representative benzenoids, such as pyrene, perylene, coronene, and benzo[ghi]perylene and their benzo and naphtho derivatives have been shown in the common literature to possess a pronounced propensity for aggregate state formation. The aggregate states of these compounds are extensively characterized in common literature. Other organic compounds meeting such a planar geometry criteria are useful as well.

Often it is found that compounds such as disclosed in the current invention are capable of forming aggregate states consisting of not only two molecules, but of three, four and more as the volume % increases. With sufficiently high number of molecules of the first host component participating in the formation of an aggregate state, a domain could be formed where certain degree of order or degree of crystallinity could be found. The size of these domains could be in the range of nanometers (nanocrystalline domain) or even micrometers (microcrystalline domain).

Materials for the second host component of the luminescent layer of the present invention include organic compounds that are capable of forming a continuous and substantially pin-hole-free thin films. They can be polar, such as the common host for green and red OLEDs A1Q, and nonpolar, such as the common hosts of anthracene family for blue OLEDs, 2-(1,1-dimethylethyl)-9,10-bis(2-naphthalenyl)anthracene (TBADN) and 9,10-Bis[4-(2,2-diphenylethenyl) phenyl]anthracene. The second host component can have a bandgap that is less than, more than, or equal to that of the first host component in its monomer state or aggregate state. The bandgap is defined as the energy needed to bring an electron from the highest occupied molecular orbital to the lowest unoccupied molecular orbital of the molecule. When the bandgap of the first host component in its monomer state is approximately equal to that of the second host component and the dopant is absent, the photoluminescence (PL) and electroluminescence (EL) spectra are composed of the emission spectra of both species. This can be seen in FIG. 4 and FIG. 6, the curves corresponding to 2% and 4% cases. When the bandgap of the first host component in its monomer state is approximately equal to that of the second host component and to that of the first host component in its aggregate state (while the dopant is absent), the PL and EL spectra are composed of the emission spectra of all three species. This can be seen in FIG. 4 and FIG. 6, the curves corresponding to 6% and 10% cases. When the bandgap of the first host component in its aggregate state is smaller than that of the second host component and the dopant is absent, the PL and EL spectra are dominated by the emission spectrum of the fist host component in its aggregate state. This can be seen in FIG. 4 and FIG. 6, the curves corresponding to 15% case. Note that in all these cases the composition of the PL and EL spectra is also a subject to concentration, particularly of the aggregates of the first host component, and lifetime of the singlet excited states of all the species involved.

The necessary condition is that the bandgap of the luminescent dopant be smaller than the bandgap of the second host component, the bandgap of first host component in its monomer state, and the bandgap of the first host component in its aggregate state. This ensures that electronic excitation energy transfer from the first and second host components, resulting from the recombination of electrons and holes in the first and second host components, to the light producing dopants is favorable.

Anyone of the second host component, the first host component in its monomer state, and the fist host component in its aggregate state can have the lowest bandgap. The lowest bandgap material may also serve as a hole trap, an electron trap, or both. Trapping injected carriers directly in one host component may be beneficial as it promotes electron-hole recombination in this component, shortcutting the need for carrier recombination in the other host component. Under this condition, the other host component is needed for carrier transport only.

A preferred class of materials for the second host component is the oxinoid compounds. Exemplary of contemplated oxinoid compounds are those satisfying the following structural formula:

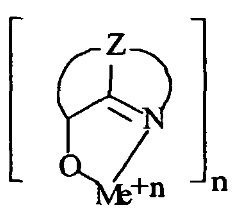

OR

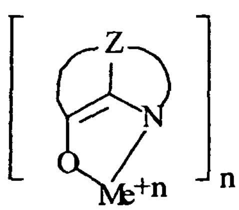

wherein

Me represents a metal;
n is an integer of from 1 to 3; and
Z independently in each occurrence represents the atoms completing a nucleus having at least two fused aromatic rings.

From the foregoing it is apparent that the metal can be monovalent, divalent, or trivalent metal. The metal can, for example, be an alkali metal, such as lithium, sodium, or potassium; an alkaline earth metal, such as magnesium or calcium; or an earth metal, such as boron or aluminum. Generally any monovalent, divalent, or trivalent metal known to be a useful chelating metal can be employed.

Z completes a heterocyclic nucleus containing at least two fused aromatic rings, at least one of which is an azole or azine ring. Additional rings, including both aliphatic and aromatic rings, can be fused with the two required rings, if required. To avoid adding molecular bulk without improving on function the number of ring atoms is preferably maintained at 18 or less.

Illustrative of useful chelated oxinoid compounds and their abbreviated names are the following:

Tris(8-quinolinol)aluminum (AlQ)
Bis(8-quinolinol)magnesium (MgQ)
Tris(8-quinolinol)indium (InQ)
8-quinolinol lithium (LiQ)

Another class of materials useful as the second host component includes benzenoids that contain other heterocyclic structures. These structures include benzoxazolyl, and thio and amino analogs of benzoxazolyl of following general molecular structure:

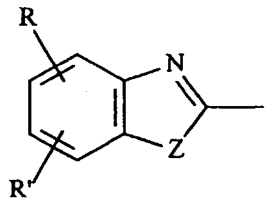

wherein
Z is O, NR'' or S; R and R', are individually hydrogen; alkyl of from 1 to 24 carbon atoms; aryl or hetero-atom substituted aryl of from 5 to 20 carbon atoms; halo, or atoms necessary to complete a fused aromatic ring; and R'' is hydrogen; alkyl of from 1 to 24 carbon atoms; or aryl of from 5 to 20 carbon atoms.

The material selection criteria for the dopant in the luminescent layer are: 1) the dopant molecule has a high efficiency of fluorescence or phosphorescence in the luminescent layer, and 2) it has a bandgap smaller than that of the both first and second host materials, the first component being either in its monomer state or its aggregate state.

For red-emitting OLEDs, a preferred class of dopants of this invention has the general formula:

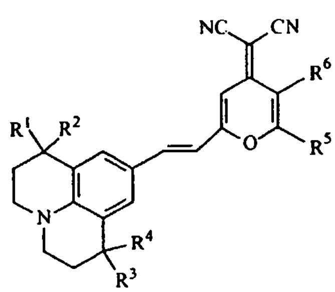

wherein:

$R^1$, $R^2$, $R^3$, and $R^4$ are individually alkyl of from 1 to 10 carbon atoms; $R^5$ is alkyl of from 2 to 20 carbon atoms, aryl, sterically hindered aryl, or heteroaryl; and $R^6$ is alkyl of from 1 to 10 carbon atoms, or a 5- or 6-membered carbocyclic ring connecting with $R^5$.

These materials possess fluorescence efficiencies as high as unity in solutions and emit in the orange and red spectral region. Representative materials of this class and their abbreviated names include:

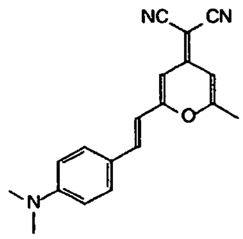

DCM

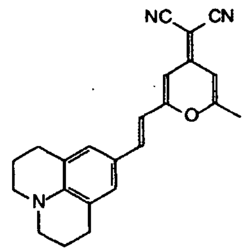

DCJ

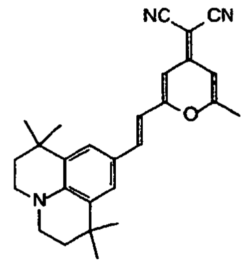

DCJT

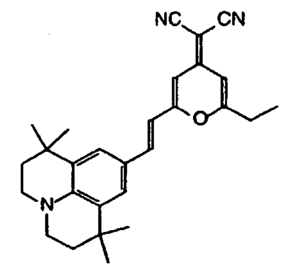

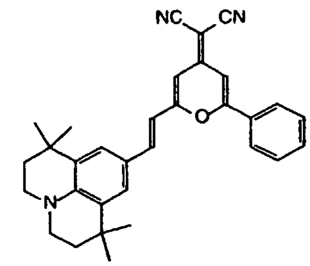

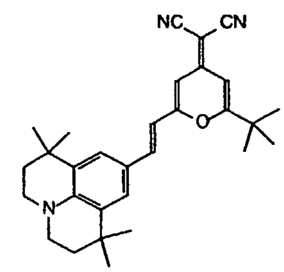

DCJTB

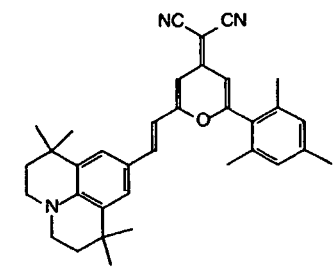

For green-emitting OLEDs, a class of fluorescent materials is useful as the dopants in the present invention, which includes compounds of the formula:

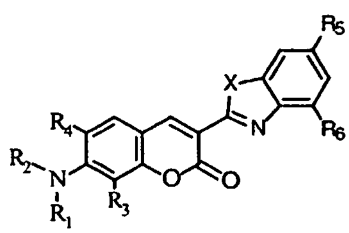

wherein:

X = S, or O; $R_1$ and $R_2$ are individually alkyl of from 1 to 20 carbon atoms, aryl or carbocyclic systems; $R_3$ and $R_4$ are individually alkyl of from 1 to 10 carbon atoms, or a branched or unbranched 5 or 6 member substituent ring connecting with $R_1$, $R_2$ respectively; and $R_5$ and $R_6$ are individually alkyl of from 1 to 20 carbon atoms, which are branched or unbranched.

Representative materials of this class and their abbreviated names include:

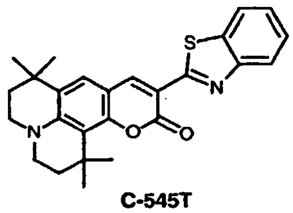

C-545T

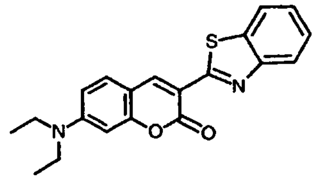

C-6

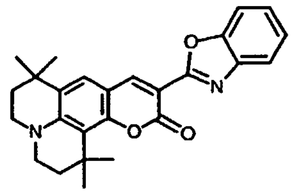

C-525T

For green-emitting OLEDs, another class of fluorescent materials is useful as the dopants in the present invention, which includes compounds of the formula:

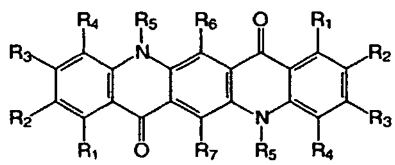

wherein:

substituents $R_1$ through $R_7$ are each individually hydrogen, fluorine, chlorine, branched or unbranched alkyl of from 1 to 24 carbon atoms, aryl, or substituted aryl of from 5 to 30 carbon atoms; or any two adjacent $R_1$ through $R_4$ substituents form an annelated benzo substituent or its alkyl or aryl substituted derivative; or any two $R_1$ through $R_{10}$ substituents form a 1,2-benzo, 1,2-naphtho, 2,3-naphtho, or 1,8-naphtho substituent or their alkyl or aryl substituted derivative.

Representative materials of this class and their abbreviated names include:

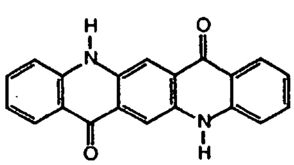

Quinacridone, QA

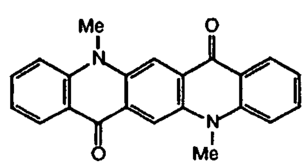

Dimethylquinacridone, DMQA

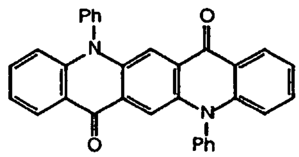

Diphenylquinacridone, DPQA

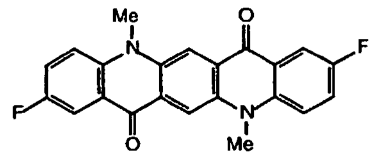

CFDMQA

The composition of the luminescent layer of this invention is such that either the first host component or the second host component constitute the largest volume fraction of the luminescent layer. The dopant usually constitutes the smallest volume fraction. The range for the first and the second host component is from 1 to 99 volume % of the luminescent layer. The preferred range for the first and the second host component is from 5 to 95% by volume. The concentration range for the dopant is from 0.1% to 10% by volume. The preferred concentration range for the dopant is from 0.5% to 5% by volume. The thickness of the luminescent layer useful in this invention is between 50 Angstroms and 2000 Angstroms. A thickness in this range is sufficiently large to enable recombination of charge carriers and, therefore, electroluminescence to take place exclusively in this layer. A preferred range is between 100 Angstroms and 500 Angstroms, where the overall OLED device performance parameters, including drive voltage, are optimal.

A useful method for forming the luminescent layer of the present invention is by vapor deposition in a vacuum chamber. This method is particularly useful for fabricating OLED devices, where the layer structure, including the organic layers, can be sequentially deposited on a substrate without significant interference among the layers. The thickness of each individual layer and its composition can be precisely controlled in the deposition process. To produce the desired composition of the luminescent layer, the rate of deposition for each component is independently controlled using a deposition rate monitor.

Returning to FIG. 2, hole-transport layer 231 and electron-transport layer 233 provide the functions of transporting holes and electrons, respectively, to the luminescent layer 232. The use of these layers and their material compositions in OLED devices have been disclosed by Tang and others, in commonly-assigned US-A-4,769,292. A typical hole-transport layer includes the hole-transporting compounds such as N,N'-bis(1-naphthyl)-N,N'-diphenylbenzidine (NPB), N,N'-bis(1-naphthyl)-N,N'-bis(2-naphthyl)benzidine (TNB), and N,N'-bis(3-tolyl)-N,N'-diphenylbenzidine (TPD).

Returning to FIG. 3, hole-injection layer 331 and electron-injection layer 335 provide the functions of improving the hole-injection from the anode and electron-injection from the cathode 340, respectively. The use of a hole-injection layer in OLED devices has been disclosed by Van Slyke and others, in commonly assigned US-A-4,720,432. The use of an electron-injection layer has been disclosed by Hung and others, in commonly assigned US-A-5,776,622.

Examples 2-6, 27-29 34-36 and 48-51 do not contain a dopant. However, although these examples do not form part of the invention they are useful for understanding the invention.

<u>Comparative Example I</u>

An OLED device 1 was prepared as follows. A glass substrate coated with about 850 Å transparent indium-tin-oxide (ITO) conductive layer was cleaned and dried using a commercial glass scrubber tool. The ITO surface was subsequently treated with an oxidative plasma to condition the surface as an anode. Over the ITO was deposited a 10 Å thick hole-injecting layer of fluorocarbon (CFx) by plasma-assisted deposition of $CHF_3$. The following layers were deposited in the following sequence by sublimation from heated crucible boats in a conventional vacuum deposition chamber under a vacuum of approximately $10^{-6}$ torr: (1) a hole-transport layer, 750Å thick, consisting of NPB, (2) a luminescent layer, 450 Å thick, consisting of Alq as the sole material, (3) an electron-transport layer, 300 Å thick, consisting of A1Q, and (4) a cathode, approximately 2200 Å thick, consisting of an alloy of magnesium and silver with a Mg:Ag volume ratio of about 10:1. Following that the device was encapsulated in nitrogen atmosphere along with calcium sulfate as a desiccant.

The EL characteristics of this device were evaluated using a constant current source and a photometer. The drive voltage, EL efficiency in cd/A and W/A, CIE coordinates, peak wavelength, $\lambda_{max}$, full spectral width at half-maximum, FWHM, and loss or gain in EL efficiency as current density, J, increases from 0.5 to 100 mA/cm$^2$, $\Delta$ cd/A vs J, at current densities ranging from relatively low, 0.5 mA/cm$^2$, to relatively high, 100 mA/cm$^2$, were measured. Their values at 20 mA/cm$^2$ are shown in Table I.

Table I also contains values of lifetimes which were measured at average current density of 40 mA/cm$^2$ (0.5 ms forward bias at 80 mA/cm$^2$ alternating with the 0.5 ms of reverse bias of -14V) and at room temperature. The devices were allowed to run for 500-1000 hours, after which time the aging was stopped and a plot of luminance versus time

was fitted with stretched exponential function of the following form:

$$L_t = L_0 \times \exp(A \times t^B),$$

where $L_t$ is luminance at time t, $L_0$ is initial luminance, A and B are empirical fit parameters, found to be -0.011 and 0.59, respectively. Half-lifetime, $T_{50\%}$, of the device was found by calculating time at which $L_t / L_0 = 0.5$.

Examples 2-6

OLED devices 2-6 similar to the device 1 of Comparative Example 1 were constructed, except that in the luminescent layer (2) naphtho[2,3-a]pyrene was used as the material for the first host component and A1Q as the material for the second host component. The relative amounts of naphtho[2,3-a]pyrene and A1Q on a volume basis were in the ratio 1:99, 2:98, 4:96, 10:90, and 15:85 for Examples 2,3,4,5, and 6, respectively. The EL characteristics of the devices 2-6 are shown in Table I. As can be seen from Table I, devices 2-6 demonstrate as volume % of naphtho[2,3-a]pyrene increases: 1) slight decrease in luminance efficiency followed by an increase; 2) shift of the emission color from green to green-yellow; 3) change in the Δ cd/A vs J behavior from gain to larger loss followed by a smaller loss; 4) from 200% to 800% improvement in lifetime relative to the Comparative Device 1.

Comparative Example 7

An OLED device 7 similar to that of Comparative Example 1 was constructed, except that the sole host material of the luminescent layer, A1Q, was doped with a luminescent dopant CFDMQA and their volume ratio was 99.5:0.5, respectively. The EL characteristics of this device are shown in Table I.

Examples 8-11

OLED devices 8-11 similar to those of Comparative Example 7 were constructed, except that the luminescent layer was prepared using naphtho[2,3-a]pyrene as the first host component, A1Q as the second host component, and CFDMQA as a dopant. The relative amounts of naphtho[2,3-a]pyrene, A1Q, and CFDMQA on a volume basis were in the ratio 1:98.5:0.5, 2:97.5:0.5, 4:95.5:0.5, and 8:91.5:0.5 for Examples 8,9,10, and 11, respectively. The EL characteristics of the devices 8-11 are shown in Table I. As can be seen, devices 8-11 demonstrate as volume % of naphtho[2,3-a]pyrene increases: 1) about 40% decrease in luminance efficiency; 2) shift of the emission color from green to green-yellow; 3) change in the Δ cd/A vs J behavior from gain to loss; 4) from 240% to 550% improvement in lifetime relative to the Comparative Device 7.

Comparative Example 12

An OLED device 12 similar to that of Comparative Example 7 was constructed, except that the sole host material of the luminescent layer, A1Q, was doped with a luminescent dopant C545T and their volume ratio was 99.5:0.5, respectively. The EL characteristics of this device are shown in Table I.

Examples 13-16

OLED devices 13-16 similar to those of Comparative Example 12 were constructed, except that the luminescent layer was prepared using

Table I. Compositions and EL properties (at 20 mA/$cm^2$) of OLED devices of Examples 1-16 [a]

| Example Or Device # | First host component N[2,3-a]P, vol% | Second host component AlQ, vol% | Dopant, vol% | Drive voltage, V | Efficiency, cd/A, W/A | CIEx | CIEy | $\lambda_{max}$, FWHM, nm | Δ cd/A vs J, % from 0.5 to 100 mA/$cm^2$ | $T_{50\%}$, h @40 mA/$cm^2$, RT |
|---|---|---|---|---|---|---|---|---|---|---|
| 1 | 0 | 100 | 0 | 8.2 | 2.43,0.018 | 0.334 | 0.551 | 528,104 | +14 | 1,100 |
| 2 | 1 | 99 | 0 | 8.3 | 2.27,0.017 | 0.309 | 0.552 | 520,100 | -20 | 3,200 |
| 3 | 2 | 98 | 0 | 8.4 | 2.03,0.016 | 0.277 | 0.537 | 516,92 | -31 | 4,700 |
| 4 | 4 | 96 | 0 | 8.3 | 2.33,0.018 | 0.287 | 0.548 | 516,92 | -40 | 7,000 |
| 5 | 10 | 90 | 0 | 8.4 | 3.14,0.022 | 0.361 | 0.560 | 536,108 | -37 | 8,200 |
| 6 | 15 | 85 | 0 | 8.3 | 3.49,0.024 | 0.402 | 0.551 | 548,104 | -31 | 10,000 |
| 7 | 0 | 99.5 | CFDMQA, 0.5 | 9.0 | 4.70,0.028 | 0.323 | 0.633 | 528,46 | +28 | 950 |
| 8 | 1 | 98.5 | CFDMQA, 0.5 | 9.2 | 2.88,0.018 | 0.336 | 0.614 | 528,60 | -12 | 3,200 |
| 9 | 2 | 97.5 | CFDMQA, 0.5 | 9.0 | 2.68,0.017 | 0.342 | 0.606 | 528,64 | -22 | 4,500 |
| 10 | 4 | 95.5 | CFDMQA, 0.5 | 8.9 | 2.68,0.017 | 0.358 | 0.595 | 528, 68 | -25 | 5,100 |
| 11 | 8 | 91.5 | CFDMQA, 0.5 | 8.9 | 2.59,0.017 | 0.386 | 0.578 | 532,76 | -21 | 6,200 |
| 12 | 0 | 99.5 | C545T, 0.5 | 8.5 | 8.70,0.055 | 0.291 | 0.646 | 520,54 | +4 | 700 [b] |
| 13 | 1 | 98.5 | C545T, 0.5 | 8.5 | 5.11,0.032 | 0.289 | 0.639 | 520,56 | -32 | 3,100 |
| 14 | 2 | 97.5 | C545T, 0.5 | 8.6 | 4.72,0.030 | 0.287 | 0.639 | 520,56 | -42 | 4,200 |
| 15 | 4 | 95.5 | C545T, 0.5 | 8.6 | 4.46,0.029 | 0.291 | 0.633 | 520,56 | -45 | 6,100 |
| 16 | 8 | 91.5 | C545T, 0.5 | 8.7 | 4.88,0.031 | 0.310 | 0.625 | 520,62 | -44 | 7,500 [b] |

(a) N[2,3-a]P - naphtho[2,3-a]pyrene; $\lambda_{max}$ - peak wavelength, nm; FWHM - full spectral width at half-maximum, nm Δ cd/A vs J - loss or gain in EL efficiency as current density, J, increases from 0.5 to 100 mA/$cm^2$; RT - room temperature; (b) $T_{50\%}$ at 20 mA/$cm^2$ and RT: Example 12 - 1600 h; Example 16 -14,200 h.

naphtho[2,3-a]pyrene as the first host component, A1Q as the second host component, and C545T as a dopant. The relative amounts of naphtho[2,3-a]pyrene, A1Q, and C545T on a volume basis were in the ratio 1:98.5:0.5, 2:97.5:0.5, 4:95.5:0.5, and 8:91.5:0.5 for Examples 13, 14, 15, and 16, respectively. The EL characteristics of the devices 13-16 are shown in Table I. As can be seen, devices 13-16 demonstrate as volume % of naphtho[2,3-a]pyrene increases: 1) about 45% decrease in luminance efficiency; 2) no significant shift of the emission color; 3) change in the Δ cd/A vs J behavior from no loss to loss; 4) from 340% to 1,000% improvement in lifetime relative to the Comparative Device 12. $T_{50\%}$ at 20 mA/cm$^2$ and RT was measured as well: 1600 h for Example 12 and 14,200 h for Example 16. This indicates 800% improvement in device lifetime.

Comparative Example 17

An OLED device 17 similar to that of Comparative Example 12 was constructed, except that: 1) the luminescent layer thickness was 300 Å; 2) the sole host material of the luminescent layer, AlQ, was doped with a luminescent dopant DCJTB and their volume ratio was 99:1, respectively. The EL characteristics of this device are shown in Table II.

Examples 18-21

OLED devices 18-21 similar to those of Comparative Example 17 were constructed, except that the luminescent layer was prepared using naphtho[2,3-a]pyrene as the first host component, A1Q as the second host component, and DCJTB as a dopant. The relative amounts ofnaphtho[2,3-a]pyrene, A1Q, and DCJTB on a volume basis were in the ratio 19.5:79.5:1.0, 39.5:59.5:1.0, 59.5:39.5:1.0, and 79.5:19.5:1.0 for Examples 18, 19, 20, and 21, respectively. The EL characteristics of the devices 18-21 are shown in Table II. As can be seen, devices 18-21 demonstrate as volume % of naphtho[2,3-a]pyrene increases: 1) about 20% reduction in the drive voltage; 2) about 80% gain in luminance efficiency; 3) shift of the emission color from orange-red to red with

Table II. Compositions and EL properties (at 20 mA/$cm^2$) of OLED devices of Examples 17-25 [a]

| Example Or Device # | First host component N[2,3-a]P, vol% | Second host component AlQ, vol% | Dopant, vol% | Drive voltage, V | Efficiency, cd/A, W/A | CIEx | CIEy | $\lambda_{max}$, FWHM, nm | $\Delta$ cd/A vs J, % from 0.5 to 100 mA/$cm^2$ | $T_{50\%}$, h @40 mA/$cm^2$, RT |
|---|---|---|---|---|---|---|---|---|---|---|
| 17 | 0 | 99 | DCJTB, 1.0 | 8.8 | 2.15,0.032 | 0.620 | 0.373 | 624,88 | -43 | 1,200 [b] |
| 18 | 19.5 | 79.5 | DCJTB, 1.0 | 7.7 | 2.44, 0.041 | 0.638 | 0.357 | 628, 84 | -30 | 4,100 [b] |
| 19 | 39.5 | 59.5 | DCJTB, 1.0 | 7.3 | 3.34, 0.057 | 0.641 | 0.356 | 628,84 | -20 | 6,000 [b] |
| 20 | 59.5 | 39.5 | DCJTB, 1.0 | 7.2 | 3.46,0.058 | 0.641 | 0.356 | 628,84 | -7 | 7,000 [b] |
| 21 | 79.5 | 19.5 | DCJTB, 1.0 | 7.0 | 3.32,0.055 | 0.641 | 0.357 | 628,84 | 0 | 6,100 [b] |
| 22 | 0 | 99 | DCJTB, 1.0 | 10.5 | 1.45,0.027 | 0.645 | 0.351 | 636,88 | -43 | 1,500 |
| 23 | 24.5 | 74.5 | DCJTB, 1.0 | 9.0 | 2.40,0.045 | 0.651 | 0.346 | 636,84 | -30 | 5,300 |
| 24 | 49.5 | 49.5 | DCJTB, 1.0 | 8.6 | 2.86,0.057 | 0.656 | 0.342 | 636,84 | -10 | 6,300 |
| 25 | 74.5 | 24.5 | DCJTB, 1.0 | 8.3 | 2.91,0.057 | 0.655 | 0.343 | 636,84 | +2 | 6,000 |

(a) N[2,3-a]P - naphtho[2,3-a]pyrene; $\lambda_{max}$ - peak wavelength, nm; FWHM - full spectral width at half-maximum, nm; $\Delta$ cd/A vs J - loss or gain in EL efficiency as current density, J, increases from 0.5 to 100 mA/$cm^2$; RT - room temperature; (b) $T_{50\%}$ at 20 mA/$cm^2$ and RT: Example 17 - 3000 h; Example 18 - 10,000 h; Example 19 - 13,500 h; Example 20 - 17,000 h; Example 21 - 14,000 h.

excellent color chromaticity; 4) change in the Δ cd/A vs J behavior from large loss to insignificant-to-no loss; 5) from 240% to 480% improvement in lifetime relative to the Comparative Device 17. $T_{50\%}$ at 20 mA/cm$^2$ and RT were measured as well, Table II, which showed from 230% to 470% improvement in device half-lifetime.

Comparative Example 22

An OLED device 22 similar that of Comparative Example 17 was constructed except the luminescent layer thickness was 450 Å. The EL characteristics of this device are shown in Table II.

Examples 23-25

OLED devices 23-25 similar to those of Comparative Example 22 were constructed, except that the luminescent layer was prepared using the relative amounts of naphtho[2,3-a]pyrene, A1Q, and DCJTB in the following volume ratio: 24.5:74.5:1.0, 49.5:49.5:1.0, and 74.5:24.5:1.0 for Examples 23, 24, and 25, respectively. The EL characteristics of the devices 23-25 are shown in Table II. As can be seen, devices 23-25 demonstrate as volume % of naphtho[2,3-a]pyrene increases: 1) about 20% reduction in the drive voltage; 2) about 110% gain in luminance efficiency; 3) shift of the emission color from red to even better red with excellent color chromaticity; 4) change in the Δ cd/A vs J behavior from large loss to insignificant-to-no loss; 5) from 250% to 320% improvement in lifetime relative to the Comparative Device 22.

Comparative Example 26

An OLED device 26 such as that of Comparative Example 1 was constructed. The EL characteristics of this device are shown in Table III.

Examples 27-29

OLED devices 27-29 similar to the device 26 of Comparative Example 26 were constructed, except that in the luminescent layer (2) naphthacene, was used as the material for the first host component and A1Q as the material for the second host component. The relative amounts of naphthacene and AlQ on a volume basis were in the ratio 1:99, 2:98, and 4:96 for Examples 27, 28 and 29, respectively. The EL characteristics of the devices 27-29 are shown in Table III. As can be seen, devices 27-29 demonstrate as volume % of naphthacene increases: 1) no significant change in the drive voltage or luminance efficiency; 2) change in the Δ cd/A vs J behavior from gain to loss; 3) from 40% to 120% improvement in lifetime relative to the Comparative Device 26.

Comparative Example 30

An OLED device 30 such as that of Comparative Example 12 was constructed. The EL characteristics of this device are shown in Table III.

Examples 31 and 32

OLED devices 31 and 32 similar to those of Comparative Example 30 were constructed, except that the luminescent layer was prepared using naphthacene as the first host component, A1Q as the second host component, and C545T as a dopant. The relative amounts of naphthacene, A1Q, and C545T on a volume basis were in the ratio 2: 97.5:0.5 and 8:91.5:0.5 for Examples 31 and 32, respectively. The EL characteristics of the devices 31 and 32 are shown in Table III. As can be seen, devices 31 and 32 demonstrate as volume % of naphthacene increases: 1) about 35% decrease in luminance efficiency; 2) no change in color; 3) change in the Δ cd/A vs J behavior from no loss to loss; 4) from 250% to 320% improvement in lifetime relative to the Comparative Device 30.

Comparative Example 33

An OLED device 33 similar to that of Comparative Example 1 was constructed, except that the sole host material of the luminescent layer was TBADN. The EL characteristics of this device are shown in Table IV.

Examples 34-36

OLED devices 34-36 similar to the device 33 of Comparative Example 33 were constructed, except that in the luminescent layer (2) naphtho[2,3-a]pyrene was used as the material for the first host component and TBADN as the

material for the second host component. The relative amounts of naphtho[2,3-a]pyrene and TBADN on a volume basis were in the ratio 2:98, 6:94,

Table III. Compositions and EL properties (at 20 $mA/cm^2$) of OLED devices of Examples 26-32 [a]

| Example Or Device # | First host component N, vol% | Second host component AlQ, vol% | Dopant, vol% | Drive voltage, V | Efficiency, cd/A, W/A | CIEx | CIEy | $\lambda_{max}$, FWHM, nm | $\Delta$cd/A vs J, % from 0.5 to 100 $mA/cm^2$ | $T_{50\%}$, h @40 $mA/cm^2$, RT |
|---|---|---|---|---|---|---|---|---|---|---|
| 26 | 0 | 100 | 0 | 7.6 | 2.96,0.021 | 0.365 | 0.554 | 540, 108 | +24 | 800 |
| 27 | 1 | 99 | 0 | 8.0 | 3.13,0.022 | 0.308 | 0.592 | 532,88 | -25 | 1,100 |
| 28 | 2 | 98 | 0 | 8.2 | 3.09,0.021 | 0.306 | 0.597 | 532,84 | -34 | 1,400 |
| 29 | 4 | 96 | 0 | 8.1 | 3.04,0.021 | 0.311 | 0.600 | 532,84 | -35 | 1,700 |
| 30 | 0 | 99.5 | C545T, 0.5 | 8.4 | 9.46,0.058 | 0.292 | 0.649 | 520, 52 | +6 | 600 |
| 31 | 2 | 97.5 | C545T, 0.5 | 8.7 | 6.31, 0.039 | 0.291 | 0.648 | 524,52 | -42 | 2,100 |
| 32 | 8 | 91.5 | C545T, 0.5 | 8.7 | 5.81,0.036 | 0.302 | 0.642 | 524, 56 | -36 | 2,500 |

(a) N - naphthacene; $\lambda_{max}$ - peak wavelength, nm; FWHM - full spectral width at half-maximum, nm; $\Delta$ cd/A vs J - loss or gain in EL efficiency as current density, J, increases from 0.5 to 100 $mA/cm^2$; RT - room temperature.

and 20:80 for Examples 34, 35, and 36, respectively. The EL characteristics of the devices 34-36 are shown in Table IV. As can be seen, devices 34-36 demonstrate as volume % of naphtho[2,3-a]pyrene increases: 1) about 15% decrease in the drive voltage; 2) no change in luminance efficiency; 3) shift in color of emission from blue-green to yellow; 4) change in the Δ cd/A vs J behavior from loss first to larger loss and then to smaller loss; 5) from 550% to 1,700% improvement in lifetime relative to the Comparative Device 33.

Comparative Example 37

An OLED device 37 similar to that of Comparative Example 33 was constructed, except that the sole host material of the luminescent layer, TBADN, was doped with a luminescent dopant C545T and their volume ratio was 99.5:0.5, respectively. The EL characteristics of this device are shown in Table IV.

Examples 38-41

OLED devices 38-41 similar to those of Comparative Example 37 were constructed, except that the luminescent layer was prepared using naphtho[2,3-a]pyrene as the first host component, TBADN as the second host component, and C54T as a dopant. The relative amounts of naphtho[2,3-a]pyrene, TBADN, and C545T on a volume basis were in the ratio 2:97.5:0.5, 4:95.5:0.5, 8:91.5:0.5, and 16:83.5:0.5 for Examples 38, 39, 40 and 41, respectively. The EL characteristics of the devices 38-41 are shown in Table IV. As can be seen, devices 38-41 demonstrate as volume % of naphtho[2,3-a]pyrene increases: 1) about 45% decrease in luminance efficiency; 2) shift in color of emission from blue-green to green-yellow; 3) change in the Δ cd/A vs J behavior from loss first to larger loss and then to smaller loss; 4) from 450% to 1,300% improvement in lifetime relative to the Comparative Device 37.

Table IV. Compositions and EL properties (at 20 mA/$cm^2$) of OLED devices of Examples 33-41 [a]

| Example Or Device # | First host component N[2,3-a]P, vol% | Second host component TBADN, vol% | Dopant, vol% | Drive voltage, V | Efficiency, cd/A, W/A | CIEx | CIEy | $\lambda_{max}$, FWHM, nm | $\Delta$cd/A vs J, % from 0.5 to 100 mA/$cm^2$ | $T_{50\%}$, h @40 mA/$cm^2$, RT |
|---|---|---|---|---|---|---|---|---|---|---|
| 33 | 0 | 100 | 0 | 8.5 | 1.20,0.026 | 0.149 | 0.135 | 460,68 | -21 | 550 |
| 34 | 2 | 98 | 0 | 7.9 | 2.59, 0.024 | 0.229 | 0.458 | 476,84 | -37 | 3600 |
| 35 | 6 | 94 | 0 | 7.4 | 3.21,0.023 | 0.340 | 0.543 | 532, 104 | -23 | 6200 |
| 36 | 20 | 80 | 0 | 7.5 | 3.73, 0.027 | 0.451 | 0.527 | 560, 104 | -11 | 10,000 |
| 37 | 0 | 99.5 | C545T, 0.5 | 8.2 | 5.66,0.046 | 0.216 | 0.550 | 496,60 | -14 | 750 |
| 38 | 2 | 97.5 | C545T, 0.5 | 8.0 | 3.63,0.029 | 0.238 | 0.560 | 500,60 | -33 | 4000 |
| 39 | 4 | 95.5 | C545T, 0.5 | 7.6 | 3.58,0.026 | 0.306 | 0.568 | 504,88 | -21 | 6000 |
| 40 | 8 | 91.5 | C545T, 0.5 | 7.7 | 3.51,0.025 | 0.337 | 0.565 | 532, 100 | -19 | 6800 |
| 41 | 16 | 83.5 | C545T, 0.5 | 7.8 | 3.65, 0.026 | 0.417 | 0.543 | 552, 112 | -13 | 10,000 |
| 42 | 0 | 99 | DCJTB, 1.0 | 7.6 | 3.74,0.031 | 0.509 | 0.459 | 578,92 | +13 | 1,000 |
| 43 | 4.5 | 94.5 | DCJTB, 1.0 | 7.1 | 2.32, 0.019 | 0.517 | 0.463 | 580, 92 | -36 | 6,300 |
| 44 | 9.5 | 89.5 | DCJTB, 1.0 | 6.9 | 2.80,0.024 | 0.535 | 0.454 | 584,88 | -31 | 9,500 |
| 45 | 19.5 | 79.5 | DCJTB, 1.0 | 6.7 | 3.40,0.030 | 0.549 | 0.443 | 588,88 | -6 | >10,000 |
| 46 | 39.5 | 59.5 | DCJTB, 1.0 | | | | | 592,88 | | |

(a) N[2,3-a]P - naphtho[2,3-a]pyrene; $\lambda_{max}$ - peak wavelength, nm; FWHM - full spectral width at half-maximum, nm; $\Delta$ cd/A vs J - loss or gain in EL efficiency as current density, J, increases from 0.5 to 100 mA/$cm^2$; RT - room temperature.

Comparative Example 42

An OLED device 42 similar to that of Comparative Example 17 was constructed, except that the sole host material of the luminescent layer, TBADN, was doped with a luminescent dopant DCJTB and their volume ratio was 99: 1.0, respectively. The EL characteristics of this device are shown in Table IV.

Examples 43-46

OLED devices 43-46 similar to those of Comparative Example 42 were constructed, except that the luminescent layer was prepared using naphtho[2,3-a]pyrene as the first host component, TBADN as the second host component, and DCJTB as a dopant. The relative amounts of naphtho[2,3-a]pyrene, TBADN, and DCJTB on a volume basis were in the ratio 4.5:94.5:1.0, 9.5:89.5:1.0, 19.5:79.5:1.0, and 39.5:59.5:1.0 for Examples 43, 44, 45 and 46, respectively. The EL characteristics of the devices 43-46 are shown in Table IV. As can be seen, devices 43-46 demonstrate as volume % of naphtho[2,3-a]pyrene increases: 1) first a decrease in luminance efficiency followed by an increase; 2) shift in color of emission from yellow-orange to orange-red; 3) change in the Δ cd/A vs J behavior from gain to first larger loss and then to almost no loss; 4) from 530% to over 900% improvement in lifetime relative to the Comparative Device 42.

Comparative Example 47

An OLED device 47 such as that of Comparative Example 33 was constructed. The EL characteristics of this device are shown in Table V.

Examples 48-51

OLED devices 48-51 similar to the device 47 of Comparative Example 47 were constructed, except that in the luminescent layer (2) pyrene was used as the material for the first host component and TBADN as the material for the second host component. The relative amounts of pyrene and TBADN on a volume basis were in the ratio 2:98, 6:94, 15:85, and 50:50 for Examples 48, 49, 50, and 51, respectively. The EL characteristics of the devices 48-51 are shown in Table V. As can be seen, devices 48-51 demonstrate from 150% to 180% improvement in lifetime relative to the Comparative Device 47.

Table V. Compositions and EL properties (at 20 $mA/cm^2$) of OLED devices of Examples 42-46 [a]

| Example Or Device # | First host component pyrene, vol% | Second host component TBADN, vol% | Dopant, vol% | Drive voltage, V | Efficiency, cd/A, W/A | CIEx | CIEy | $\lambda_{max}$, FWHM, nm | $\Delta$ cd/A vs J, % from 0.5 to 100 $mA/cm^2$ | $T_{50\%}$, h @40 $mA/cm^2$, RT |
|---|---|---|---|---|---|---|---|---|---|---|
| 47 | 0 | 100 | 0 | 8.7 | 1.33,0.026 | 0.166 | 0.163 | 460,68 | -12 | 225 |
| 48 | 2 | 98 | 0 | 9.0 | 1.28, 0.026 | 0.161 | 0.156 | 460,68 | -12 | 620 |
| 49 | 6 | 94 | 0 | 9.2 | 1.30,0.027 | 0.162 | 0.151 | 456,68 | -16 | 570 |
| 50 | 15 | 85 | 0 | 9.0 | 1.29,0.027 | 0.162 | 0.152 | 460,68 | -13 | 570 |
| 51 | 50 | 50 | 0 | 9.4 | 1.24,0.023 | 0.165 | 0.177 | 464,72 | -11 | 590 |

(a) peak wavelength, nm; FWHM - full spectral width at half-maximum, nm; $\Delta$ cd/A vs J - loss or gain in EL efficiency as current density, J, increases from 0.5 to 100 $mA/cm^2$; RT - room temperature.

## Claims

1. An organic light emitting device, comprising:

   (a) a substrate;
   (b) an anode and a cathode disposed over the substrate;
   (c) a luminescent layer disposed between the anode and the cathode wherein the luminescent layer includes a host and at least one dopant;
   (d) the host of the luminescent layer being selected to include a solid organic material comprising a mixture of at least two components wherein:

      (i) the first component of the mixture is an organic polycyclic aromatic hydrocarbon compound that is capable of transporting either electrons or holes or both and forms an aggregate state either in a ground electronic state or in an excited electronic state that results in an absorption or emission spectrum different from that of the monomer state, respectively; and
      (ii) the second component of the mixture is an organic compound that is capable of forming a continuous and substantially pin-hole-free layer; and

   (e) the dopant of the luminescent layer being selected to produce light from the light-emitting device.

2. The organic light emitting device of claim 1 wherein the aggregate is a dimer in either ground electronic state or excited electronic state.

3. The organic light emitting device of claim 1 wherein the first component is an organic compound that includes a benzenoid hydrocarbon.

4. The organic light emitting device of claim 1 wherein the first component includes a benzenoid hydrocarbon or a derivative thereof substituted with a donor or an acceptor moiety.

5. The organic light emitting device of claim 1 wherein the second component includes a benzenoid hydrocarbon or a derivative thereof substituted with a donor or an acceptor moiety.

6. The organic light emitting device of claim 1 wherein the second component includes organic compounds of molecular structure:

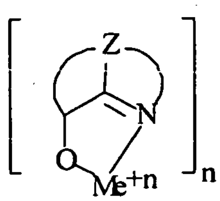

OR

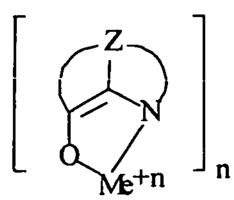

wherein

   Me represents a metal;
   n is an integer of from 1 to 3; and
   Z independently in each occurrence represents the atoms completing a nucleus having at least two fused aromatic rings.

7. The organic light emitting device of claim 6 wherein the second component includes $AlQ_3$, $InQ_3$, $GaQ_3$, or $MgQ_2$.

8. The organic light emitting device of claim 1 wherein the first component is naphthopyrene or a derivative thereof.

9. The organic light emitting device of claim 1 wherein the first component is naphthacene or a derivative thereof.

10. The organic light emitting device of claim 1 wherein the first component is perylene or a derivative thereof.

**11.** The organic light emitting device of claim 1 wherein the first component is fluoranthene or a derivative thereof.

**12.** The organic light emitting device of claim 1 wherein the first component is anthracene or a derivative thereof.

**13.** The organic light emitting device of claim 1 wherein the first component is anthanthrene or a derivative thereof.

**14.** The organic light emitting device of claim 1 wherein the first component is chrysene or a derivative thereof.

**Patentansprüche**

**1.** Organische Leuchtvorrichtung mit:

a) einem Substrat;
b) einer über dem Substrat angeordneten Anode und Kathode;
c) einer zwischen der Anode und der Kathode angeordneten Lumineszenzschicht, worin die Lumineszenzschicht ein Wirts- und mindestens ein Dotierungsmaterial beinhaltet;
d) einem Wirtsmaterial der Lumineszenzschicht, das derart ausgewählt ist, dass es ein festes organisches Material beinhaltet, das eine Mischung aus mindestens zwei Komponenten umfasst, worin:

i) die erste Komponente der Mischung eine organische polyzyklische aromatische Kohlenwasserstoffverbindung ist, die entweder Elektronen oder Löcher oder beides zu transportieren vermag und einen Aggregatzustand entweder in einem elektronischen Grundzustand oder in einem elektronischen Anregungszustand bildet, der zu einem Absorptions- bzw. Emissionsspektrum führt, das sich von dem des Monomerzustands unterscheidet; und
ii) die zweite Komponente der Mischung eine organische Verbindung ist, die eine kontinuierliche und im Wesentlichen nadellochfreie Schicht zu bilden vermag; und

e) einem Dotierungsmaterial der Lumineszenzschicht, das derart ausgewählt ist, dass es Licht aus der Leuchtvorrichtung erzeugt.

**2.** Organische Leuchtvorrichtung nach Anspruch 1, worin das Aggregat ein Dimer entweder im elektronischen Grundzustand oder im elektronischen Anregungszustand ist.

**3.** Organische Leuchtvorrichtung nach Anspruch 1, worin die erste Komponente eine organische Verbindung ist, die einen benzoiden Kohlenwasserstoff beinhaltet.

**4.** Organische Leuchtvorrichtung nach Anspruch 1, worin die erste Komponente einen benzoiden Kohlenwasserstoff oder ein Derivat davon umfasst, der bzw. das mit einem Donator- oder einem Akzeptorstoff substituiert ist.

**5.** Organische Leuchtvorrichtung nach Anspruch 1, worin die zweite Komponente einen benzoiden Kohlenwasserstoff oder ein Derivat davon umfasst, der bzw. das mit einem Donator- oder einem Akzeptorstoff substituiert ist.

**6.** Organische Leuchtvorrichtung nach Anspruch 1, worin die zweite Komponente organische Verbindungen von molekularer Struktur beinhaltet:

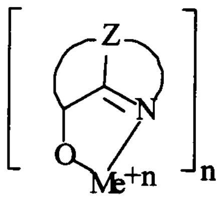

oder

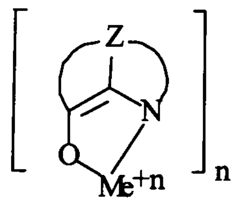

wobei

Me für ein Metall steht,
n für eine ganze Zahl von 1 bis 3 steht; und
Z unabhängig jeweils für die Atome steht, die einen Kern mit mindestens zwei kondensierten aromatischen Ringen bilden.

7. Organische Leuchtvorrichtung nach Anspruch 6, worin die zweite Komponente $AlQ_3$, $InQ_3$, $GaQ_3$ oder $MgQ_2$ beinhaltet.

8. Organische Leuchtvorrichtung nach Anspruch 1, worin die erste Komponente Naphthopyren oder ein Derivat davon ist.

9. Organische Leuchtvorrichtung nach Anspruch 1, worin die erste Komponente Naphthacen oder ein Derivat davon ist.

10. Organische Leuchtvorrichtung nach Anspruch 1, worin die erste Komponente Perylen oder ein Derivat davon ist.

11. Organische Leuchtvorrichtung nach Anspruch 1, worin die erste Komponente Fluoranthen oder ein Derivat davon ist.

12. Organische Leuchtvorrichtung nach Anspruch 1, worin die erste Komponente Anthracen oder ein Derivat davon ist.

13. Organische Leuchtvorrichtung nach Anspruch 1, worin die erste Komponente Anthanthren oder ein Derivat davon ist.

14. Organische Leuchtvorrichtung nach Anspruch 1, worin die erste Komponente Chrysen oder ein Derivat davon ist.

## Revendications

1. Dispositif électroluminescent organique, comprenant :

   (a) un substrat,
   (b) une anode et une cathode disposées sur le substrat,
   (c) une couche luminescente disposée entre l'anode et la cathode, où la couche luminescente comprend un hôte et au moins un dopant,
   (d) l'hôte de la couche luminescente étant sélectionné pour inclure un matériau organique solide comprenant un mélange d'au moins deux composants, où :

      (i) le premier composant du mélange est un composé d'hydrocarbure aromatique polycyclique organique qui est capable de transporter soit des électrons, soit des trous, ou les deux, et forme un état d'agrégat soit dans un état électronique de masse, soit dans un état électronique excité, qui résulte en un spectre d'absorption ou d'émission différent de celui de l'état de monomère, respectivement, et
      (ii) le deuxième composant du mélange est un composé organique qui est capable de former une couche continue et globalement exempte de trous d'épingle, et

   (e) le dopant de la couche luminescente étant sélectionné pour produire de la lumière à partir du dispositif électroluminescent.

2. Dispositif électroluminescent organique selon la revendication 1, dans lequel l'agrégat est un dimère soit dans un état électronique de masse, soit dans un état électronique excité.

3. Dispositif électroluminescent organique selon la revendication 1 , dans lequel le premier composant est un composé organique qui comprend un hydrocarbure benzénique.

4. Dispositif électroluminescent organique selon la revendication 1, dans lequel le premier composant comprend un hydrocarbure benzénique ou un dérivé de celui-ci ayant subi une substitution avec un donneur ou un groupe fonctionnel accepteur.

5. Dispositif électroluminescent organique selon la revendication 1, dans lequel le deuxième composant comprend un hydrocarbure benzénique ou un dérivé de celui-ci ayant subi une substitution avec un donneur ou un groupe fonctionnel accepteur.

6. Dispositif électroluminescent organique selon la revendication 1, dans lequel le deuxième composant comprend des composés organiques de structure moléculaire :

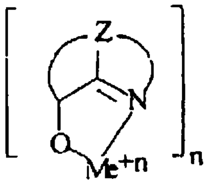

OU

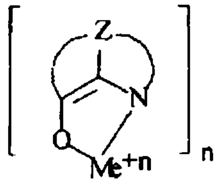

où

Me représente un métal,
n est un nombre entier entre 1 et 3, et
Z représente indépendamment dans chaque occurrence des atomes complétant un noyau ayant au moins deux cycles aromatiques condensés.

7. Dispositif électroluminescent organique selon la revendication 6, dans lequel le deuxième composant comprend $AlQ_3$, $InQ_3$, $GaQ_3$ ou $MgQ_2$.

8. Dispositif électroluminescent organique selon la revendication 1, dans lequel le premier composant est le naphtopyrène ou un dérivé de celui-ci.

9. Dispositif électroluminescent organique selon la revendication 1, dans lequel le premier composant est le naphtacène ou un dérivé de celui-ci.

10. Dispositif électroluminescent organique selon la revendication 1, dans lequel le premier composant est le pérylène ou un dérivé de celui-ci.

11. Dispositif électroluminescent organique selon la revendication 1, dans lequel le premier composant est du fluoranthène ou un dérivé de celui-ci.

12. Dispositif électroluminescent organique selon la revendication 1, dans lequel le premier composant est de l'anthracène ou un dérivé de celui-ci.

13. Dispositif électroluminescent organique selon la revendication 1, dans lequel le premier composant est de l'anthanthrène ou un dérivé de celui-ci.

14. Dispositif électroluminescent organique selon la revendication 1, dans lequel le premier composant est du chrysène ou un dérivé de celui-ci.

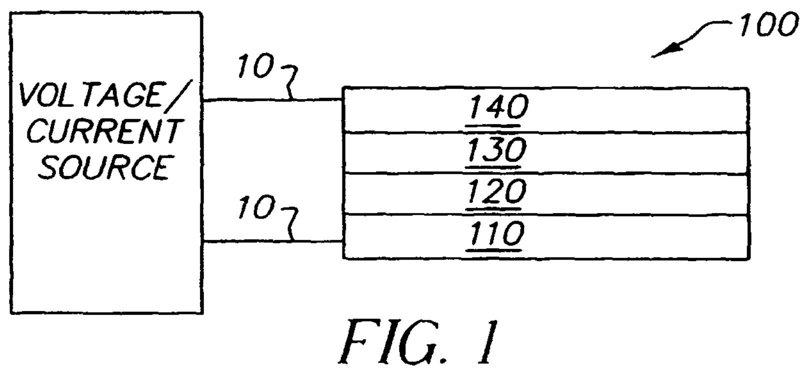


FIG. 1

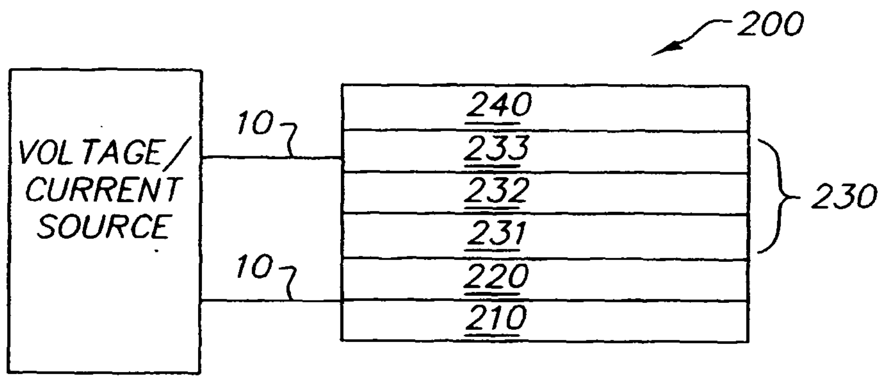


FIG. 2

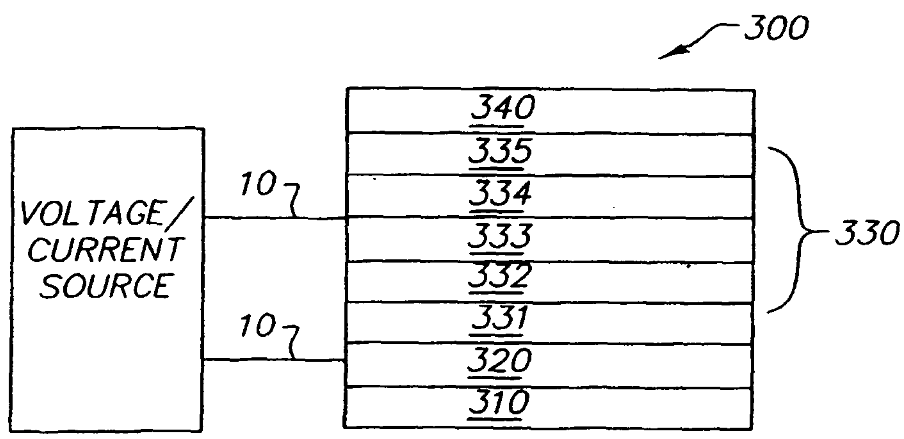


FIG. 3

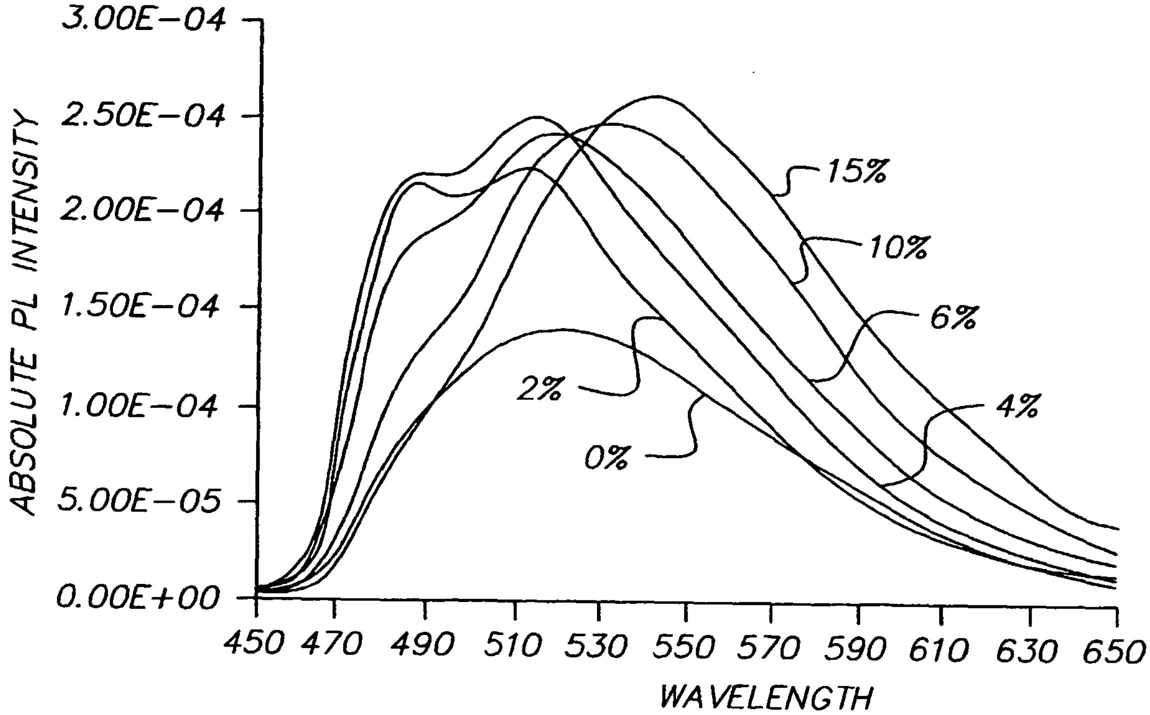
3.00E-04
2.50E-04
2.00E-04
1.50E-04
1.00E-04
5.00E-05
0.00E+00
ABSOLUTE PL INTENSITY
450 470 490 510 530 550 570 590 610 630 650
WAVELENGTH
15%
10%
6%
4%
2%
0%

FIG. 4

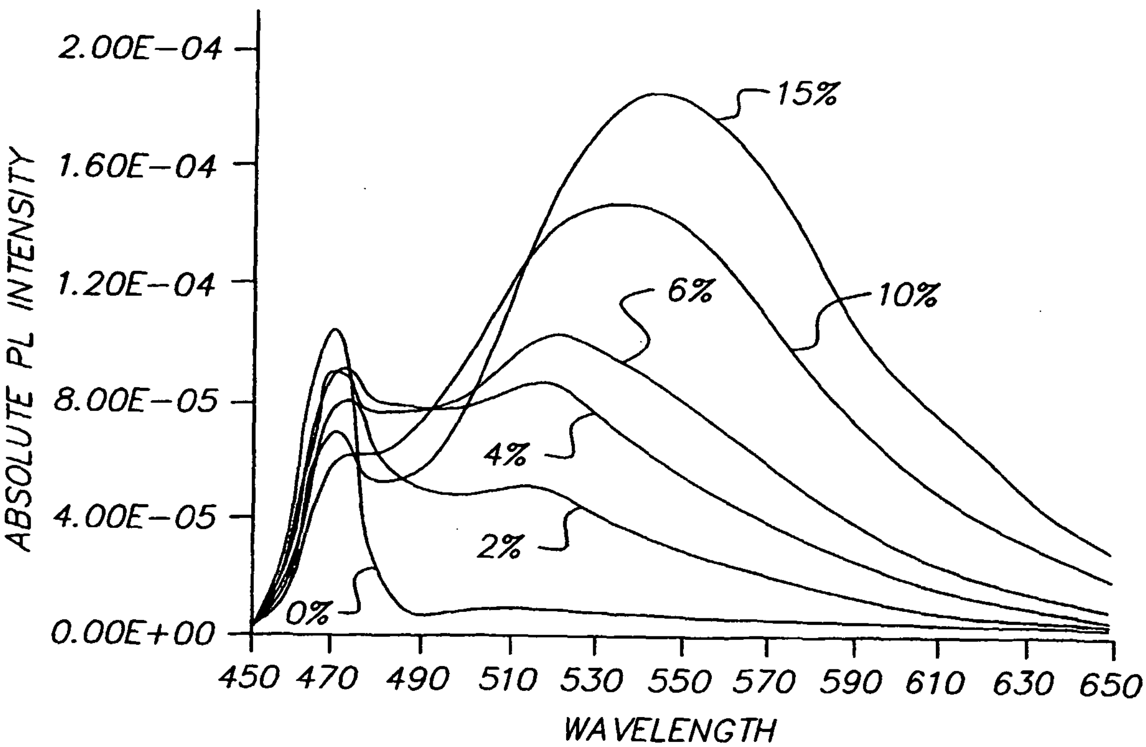
2.00E-04
1.60E-04
1.20E-04
8.00E-05
4.00E-05
0.00E+00
ABSOLUTE PL INTENSITY
450 470 490 510 530 550 570 590 610 630 650
WAVELENGTH
15%
10%
6%
4%
2%
0%

FIG. 5

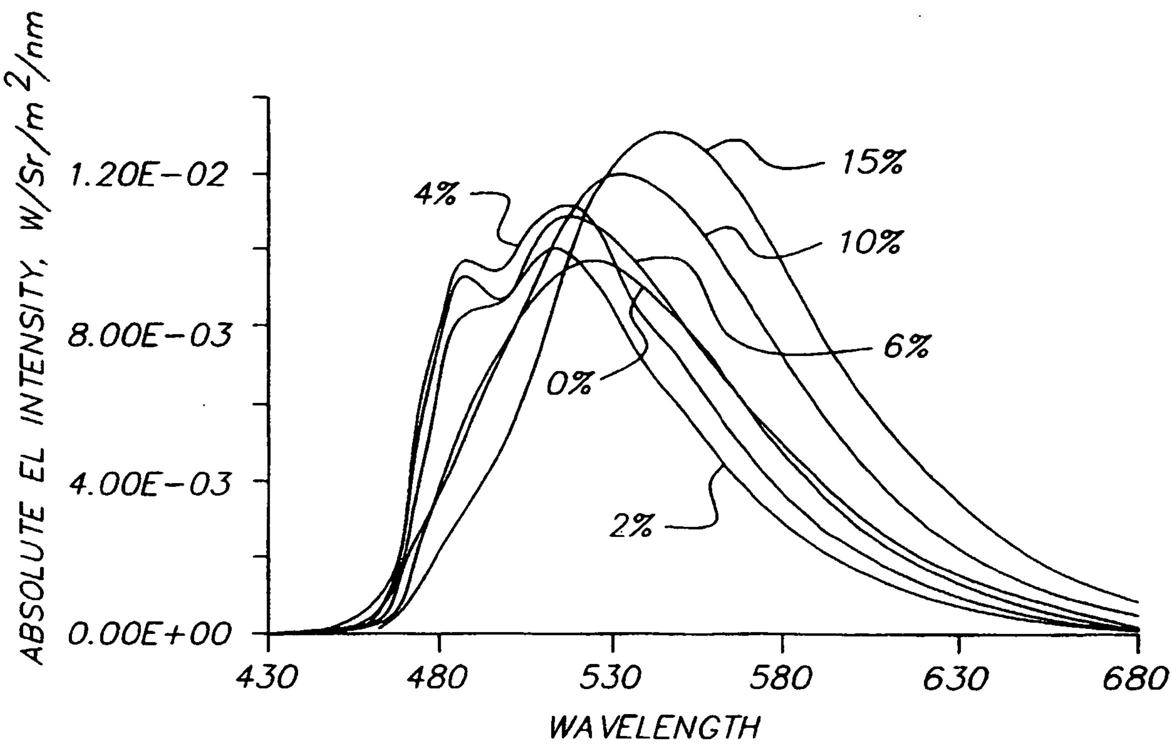
ABSOLUTE EL INTENSITY, W/Sr/m 2/nm
1.20E-02
8.00E-03
4.00E-03
0.00E+00
430
480
530
580
630
680
WAVELENGTH
15%
4%
10%
6%
0%
2%

FIG. 6

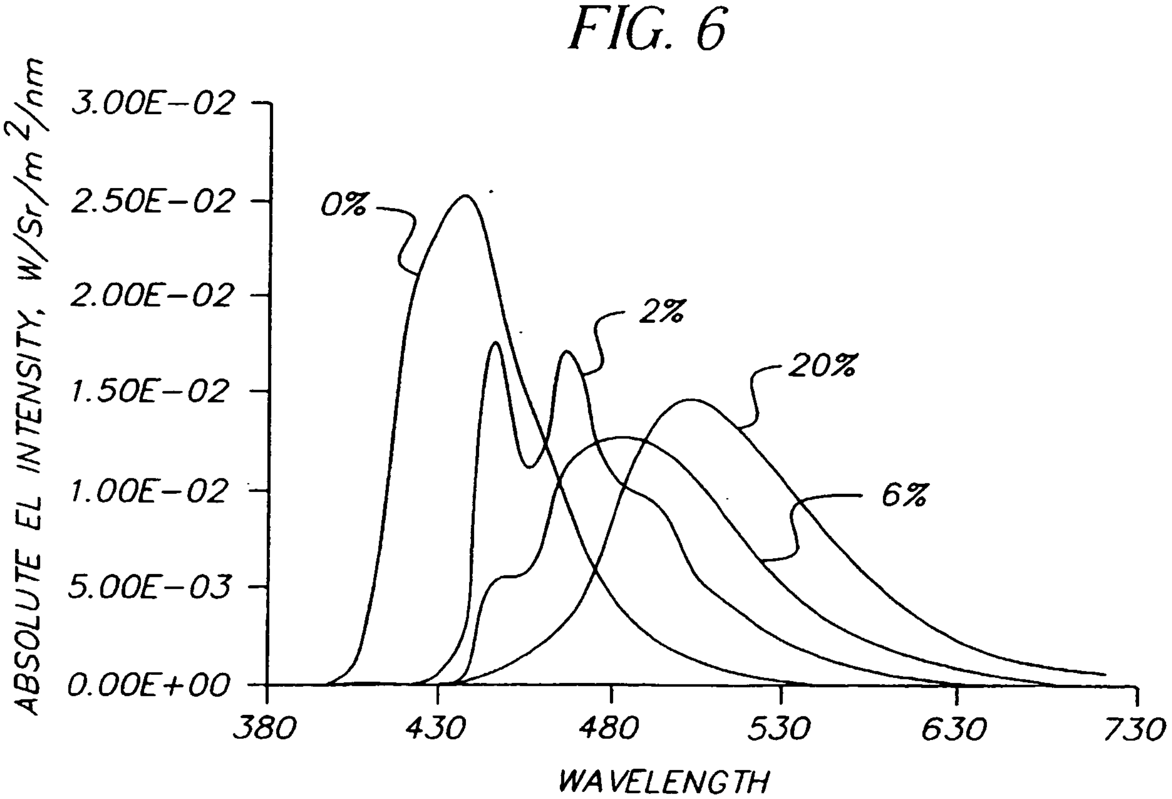
ABSOLUTE EL INTENSITY, W/Sr/m 2/nm
3.00E-02
2.50E-02
2.00E-02
1.50E-02
1.00E-02
5.00E-03
0.00E+00
380
430
480
530
630
730
WAVELENGTH
0%
2%
20%
6%

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4769292 A
- US 5908581 A
- US 5593788 A
- US 5141671 A
- JP 99273861 B
- JP 284050 A
- EP 1162674 A
- US 4720432 A
- US 5776622 A


### Non-patent literature cited in the description


- **DRESNER.** *RCA Review,* 1969, vol. 30, 322
- **TANG.** *Applied Physics Letters,* 1987, vol. 51, 913
- *Journal of Applied Physics,* 1989, vol. 65, 3610
- **POPOVIC.** *Thin Solid Films,* 2000, vol. 363, 6
- *SPIE,* 1998, vol. 3476, 68
- **HAMADA.** *Applied Phys. Lett.,* 1999, vol. 75, 1682